Europäisches Patentamt

European Patent Office

Office européen des brevets

(19)

(11) **EP 1 054 409 A1**

(12) **DEMANDE DE BREVET EUROPEEN**

(43) Date de publication:
**22.11.2000 Bulletin 2000/47**

(51) Int. Cl.$^7$: **G11C 27/02**, H03K 17/66

(21) Numéro de dépôt: **00201676.4**

(22) Date de dépôt: **10.05.2000**

(84) Etats contractants désignés:
**AT BE CH CY DE DK ES FI FR GB GR IE IT LI LU MC NL PT SE**
Etats d'extension désignés:
**AL LT LV MK RO SI**

(30) Priorité: **18.05.1999 FR 9906299**

(71) Demandeur:
**Koninklijke Philips Electronics N.V.
5621 BA Eindhoven (NL)**

(72) Inventeur: **Darthenay, Frédéric
75008 Paris (FR)**

(74) Mandataire:
**de la Fouchardière, Marie-Noelle
Société Civile "SPID"
156, Boulevard Haussmann
75008 Paris (FR)**

(54) **Dispositif de mémorisation à faible bruit et à fréquence d'échantillonnage élevée**

(57)     La présente invention concerne un dispositif de mémorisation incluant un élément capacitif C1, dont une borne est reliée via un interrupteur SW1 à une entrée destinée à recevoir un signal d'entrée Vccd.
Selon l'invention, l'interrupteur SW1 comprend un premier et un deuxième transistor bipolaire T1 et T2, dont les trajets de courant principaux sont disposés tête-bêche entre l'entrée et l'élément capacitif C1, et est en outre muni de moyens de contrôle pour alternativement extraire ou injecter du courant dans les bases des premier et deuxième transistors T1 et T2. L'invention permet de mémoriser la valeur du signal d'entrée Vccd avec une fréquence d'échantillonnage élevée et un niveau de bruit réduit par rapport à celui des dispositifs de mémorisation connus.

FIG.2

EP 1 054 409 A1

**Description**

La présente invention concerne un dispositif de mémorisation muni de bornes d'entrée et de sortie respectivement destinées à recevoir et à délivrer des signaux d'entrée et de sortie, dispositif incluant un élément capacitif, dont une borne forme la borne de sortie du dispositif et est reliée à la borne d'entrée via un interrupteur.

De tels dispositifs sont couramment utilisés dans des caméras vidéo pour générer des signaux vidéo, en amont d'unités de traitement de signal, sur la base de signaux délivrés par des capteurs de lumière, par exemple des capteurs de type CCD. Un tel capteur délivre un signal pseudo périodique présentant successivement, au cours d'une même pseudo période, un niveau dit de référence et un niveau dit vidéo. C'est la différence entre ces deux niveaux qui constitue le signal vidéo qui doit être exploité par l'unité de traitement de signal. Un dispositif de génération de signal vidéo comporte donc usuellement un premier et un deuxième dispositif de mémorisation, respectivement destinés à mémoriser les niveaux de référence et vidéo à chaque pseudo période, et un soustracteur destiné à opérer une différence entre lesdits niveaux.

Un tel dispositif de génération est notamment décrit dans le brevet US No. 4,987,321. Les interrupteurs utilisés dans les dispositifs de mémorisation inclus dans le dispositif de génération connu sont constitués par des transistors de type NMOS. Or, les transistors de ce type ont des vitesses de commutation relativement faibles, de l'ordre de la dizaine de nanosecondes, ce qui implique que les mémorisations ne peuvent être correctement opérées que pour des signaux d'entrée dont la fréquence ne dépasse pas la centaine de MégaHertz. De plus, lorsqu'un transistor NMOS est passant, il présente une résistance, appelée résistance passante, dont la valeur n'est pas négligeable. A titre d'exemple, un transistor NMOS de dimensions qui seront appelées standard dans la suite de cet exposé, c'est-à-dire possédant une largeur de grille de 0,5 microns et une longueur de grille de 100 microns, alimenté sous 3V, présentera une résistance passante de l'ordre de la centaine d'Ohms. Une telle résistance passante génère un bruit dans le signal mémorisé, et donc dans le signal vidéo, qui peut être néfaste à la bonne exploitation de ce dernier. Ce bruit peut être compensé en choisissant des transistors NMOS de grandes dimensions pour réaliser les interrupteurs, mais un tel mode de réalisation est alors coûteux en termes de surface de silicium et de consommation énergétique du dispositif de génération.

La présente invention a pour but de remédier dans une large mesure à ces inconvénients, en proposant un dispositif de mémorisation qui peut opérer à des fréquences relativement élevées, et qui génère moins de bruit que les dispositifs connus, sans pour autant nécessiter une grande surface de silicium pour se réaliser.

En effet, un dispositif de mémorisation conforme au paragraphe introductif est caractérisé selon l'invention en ce que l'interrupteur comprend un premier et un deuxième transistor bipolaire, dont les trajets de courant principaux sont disposés tête-bêche entre les bornes d'entrée et de sortie, l'interrupteur étant en outre muni de moyens de contrôle pour alternativement extraire ou injecter du courant dans les bases des premier et deuxième transistors.

Les transistors bipolaires ont des temps de commutation intrinsèquement plus faibles que ceux des transistors de type MOS, et peuvent donc opérer à des fréquences plus élevées. Ces temps de commutation sont encore réduits du fait que les transistors sont commandés en courant. L'utilisation de deux transistors dont les trajets de courant sont tête-bêche permet en outre d'assurer une conduction de courant optimale vers ou depuis l'élément capacitif. Enfin, à dimensions semblables, un transistor bipolaire présente une résistance passante intrinsèquement plus faible que celle d'un transistor de type NMOS, et indépendante de la consommation énergétique dudit transistor bipolaire.

Dans un mode de réalisation particulier de l'invention, un dispositif de mémorisation tel que décrit plus haut est caractérisé en ce que les moyens de contrôle incluent une première et une deuxième source de courant contrôlable, respectivement disposées entre les bases des premier et deuxième transistors et des première et deuxième bornes d'alimentation, les bases des premier et deuxième transistors étant court-circuitées.

Dans ce mode de réalisation, la première source de courant commande la conduction des premier et deuxième transistors, tandis que la deuxième source de courant commande l'interruption de ladite conduction. Cette interruption est très rapide, car la deuxième source de courant extrait des charges directement depuis les bases des premier et deuxième transistors. Les première et deuxième sources de courant sont commandées par des signaux qui sont générés en dehors du dispositif de mémorisation, sur la base du signal d'entrée, selon une technique connue de l'homme du métier.

Dans un mode de réalisation préféré de l'invention, le dispositif de mémorisation comporte des moyens pour empêcher une conduction simultanée des première et deuxième sources de courant.

Ce mode de réalisation élimine toute possibilité pour que les signaux de commande des première et deuxième sources de courant soient actifs en même temps, et permet d'immuniser l'interrupteur contre tout court-circuit entre les deux sources de courant.

Dans une variante de l'invention, le dispositif de mémorisation comporte un élément régulateur de tension disposé entre la borne de sortie et les bases des premier et deuxième transistors, permettant de limiter l'amplitude des tensions base-émetteur des premier et deuxième transistors.

L'élément régulateur de tension, qui pourra par exemple être de type suiveur, assure que la valeur du potentiel des bases des premier et deuxième transistors est du même ordre que celle des composantes continues des signaux d'entrée et de sortie. L'amplitude des tensions base-émetteur des premier et deuxième transistors restera donc faible, ce qui limite l'usure desdits transistors et contribue à augmenter la durée de vie du dispositif de mémorisation. De plus, cet élément régulateur permet d'éviter que de trop fortes tensions base-émetteur ne déclenchent la conduction des transistors bipolaires lorsque la première source de courant n'est pas conductrice.

Si la présente invention peut être utilisée dans tous types d'applications impliquant la mémorisation d'un signal analogique, sa mise en oeuvre est particulièrement avantageuse dans le cadre du traitement de signaux issus de capteurs de lumière. L'invention concerne donc également un dispositif de génération d'un signal vidéo, muni d'une entrée destinée à recevoir un signal d'entrée pseudo périodique présentant successivement, au cours de chaque pseudo période, un niveau dit de référence et un niveau dit vidéo, et d'une sortie destinée à délivrer un signal de sortie représentatif d'une différence entre lesdits niveaux, dispositif comportant :

. un premier et un deuxième dispositif de mémorisation, respectivement destinés à mémoriser les niveaux de référence et vidéo à chaque pseudo période, et

. un soustracteur destiné à opérer une différence entre lesdits niveaux,
dispositif caractérisé en ce que les premier et deuxième dispositifs de mémorisation sont tels que décrits plus haut.

Enfin, dans un dé ses modes de mise en oeuvre les plus avantageux, l'invention porte aussi sur un dispositif d'acquisition d'images, par exemple une caméra vidéo ou un appareil photo numérique, contenant :

. un dispositif de détection et de conversion de lumière en un signal électronique pseudo périodique,

. un étage d'entrée destiné à recevoir ledit signal électronique, et à délivrer un signal vidéo, et

. une unité de traitement de signal destinée à exploiter ledit signal vidéo,
dispositif d'acquisition caractérisé en ce que l'étage d'entrée inclut un dispositif de génération tel que décrit ci-dessus.

L'invention sera mieux comprise à l'aide de la description suivante, faite à titre d'exemple non-limitatif et en regard des dessins annexés, dans lesquels:

- la figure 1 est un schéma fonctionnel décrivant un dispositif de génération d'un signal vidéo,
- la figure 2 est un schéma électrique décrivant un dispositif de mémorisation conforme à l'invention,
- la figure 3 est un schéma fonctionnel partiel décrivant une caméra mettant en oeuvre l'invention, et
- la figure 4 est un ensemble de chronogrammes décrivant l'évolution de signaux présents dans une telle caméra.

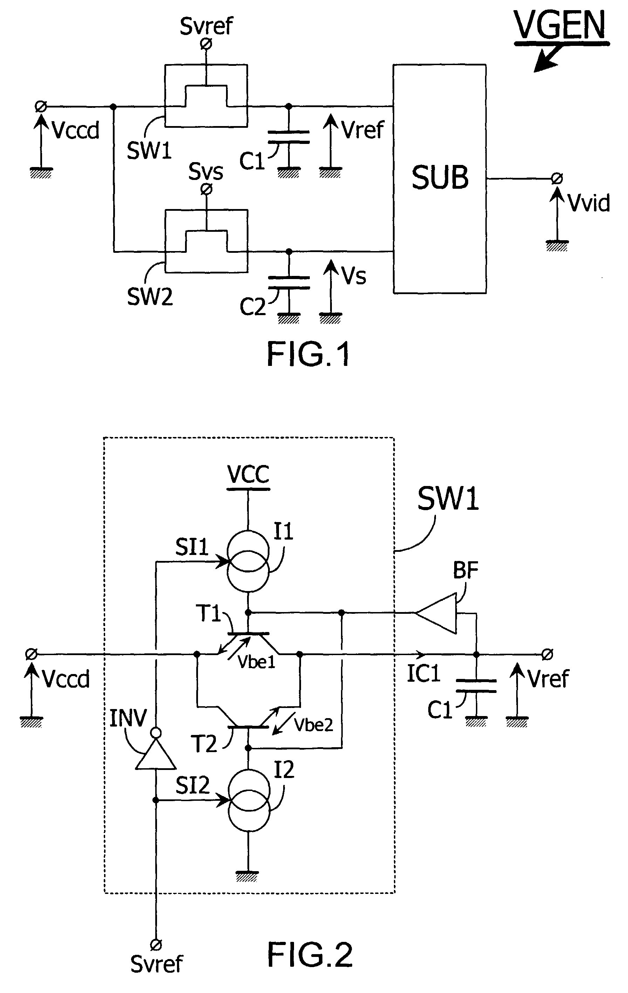

La figure 1 représente schématiquement un dispositif de génération VGEN d'un signal vidéo Vvid, muni d'une entrée destinée à recevoir un signal d'entrée Vccd pseudo périodique présentant successivement, au cours de chaque pseudo période, un niveau dit de référence et un niveau dit vidéo, et d'une sortie destinée à délivrer un signal de sortie Vvid représentatif d'une différence entre lesdits niveaux. Ce dispositif de génération VGEN comporte:

. un premier dispositif de mémorisation (SW1, C1), destiné à recevoir le signal d'entrée Vccd et à mémoriser le niveau de référence à chaque pseudo période,

. un deuxième dispositif de mémorisation (SW2, C2), destiné à recevoir le signal d'entrée Vccd et à mémoriser le niveau vidéo à chaque pseudo période, et

. un soustracteur SUB destiné à opérer une différence entre lesdits niveaux et à délivrer le signal de sortie Vvid.

Chacun des dispositifs de mémorisation comprend un élément capacitif (C1, C2), dont une borne forme la borne de sortie du dispositif et est reliée à la borne d'entrée via un interrupteur (SW1, SW2), qui est commandé par un signal (Svref, Svs) qui est actif et commande la conduction dudit interrupteur SW1 ou SW2 lorsque le niveau du signal d'entrée Vccd est celui que l'élément capacitif auquel ledit interrupteur est relié doit mémoriser, et inactif sinon. Chaque élément capacitif (C1, C2) présente à ses bornes une tension (Vref, Vs) qui est constante et représentative du niveau mémorisé lorsque le signal de commande (Svref, Svs) est inactif.

La figure 2 est un schéma électrique qui représente un dispositif de mémorisation (SW1, C1) conforme à l'invention. Dans ce dispositif, l'interrupteur SW1 comprend un premier et un deuxième transistor bipolaire (T1, T2), dont les trajets de courant principaux, constitués par leurs jonctions collecteur-émetteur, sont disposés tête-bêche entre les bornes d'entrée et de sortie du dispositif de mémorisation, l'interrupteur SW1 étant en outre muni de moyens de contrôle pour alternativement extraire ou injecter du courant dans les bases des premier et deuxième transistors (T1, T2). Ces moyens de contrôle, incluent, dans cet exemple, une première et une deuxième source de courant contrôlable (I1, I2), respectivement disposées entre les bases des premier et deuxième transistors et une borne d'alimentation VCC et la masse du dispositif, les bases des premier et deuxième transistors (T1, T2) étant court-circuitées.

Ce dispositif fonctionne comme suit:

La conduction des première et deuxième sources de courant (I1, I2) est contrôlée par des premier et deuxième signaux de commande (SI1, SI2). Lorsque, dans une phase dite de suivi, le premier signal de commande SI1 est actif, par exemple au niveau logique 1, tandis que le deuxième signal de commande SI2 est inactif, c'est-à-dire dans cet exemple au niveau logique 0, la première source de courant I1 conduit, et injecte un courant dans les bases des premier et deuxième transistors (T1, T2) qui deviennent ainsi potentiellement conducteurs. Si la tension Vccd est plus grande que la tension Vref présente aux bornes de l'élément capacitif C1, ledit élément C1 se charge au moyen d'un courant IC1 positif. C'est alors le deuxième transistor T2 qui est conducteur. Si, par contre, la tension Vccd est plus petite que la tension Vref présente aux bornes de l'élément capacitif C1, ledit élément C1 se décharge au moyen d'un courant IC1 négatif. C'est alors le premier transistor T1 qui est conducteur. Ainsi, lorsque la première source de courant I1 est conductrice, la tension d'entrée Vccd est recopiée aux bornes de l'élément capacitif C1.

Lorsque la première source de courant I1 est conductrice, une résistance passante, notée Ron, apparaît entre les bornes d'entrée et de sortie du dispositif de mémorisation. Cette résistance passante peut être exprimée sous la forme $Ron = Vce_{sat}/IC1$, où $Vce_{sat}$ est la tension de saturation de celui des premier ou deuxième transistors, T1 ou T2, qui est conducteur, soit encore $Ron = 5.Vt/(\beta.I1)$, β étant le gain de l'un des premier ou deuxième transistors T1 ou T2, Vt étant égal à $k.T/q$ où k est la constante de Boltzmann, T la température absolue et q la charge de l'électron. A 25°C, Vt=26mV, et avec un gain β=50 pour un transistor bipolaire de dimensions équivalentes aux dimensions standard définies plus haut, et I1=300μA, Ron est inférieur à une dizaine d'Ohms, soit plus de dix fois plus faible que la résistance passante d'un transistor de type NMOS de dimensions similaires. Le dispositif de mémorisation conforme à l'invention génère donc un bruit bien moins important que celui généré par les dispositifs connus.

Lorsque, dans une phase dite de maintien, le deuxième signal de commande SI2 est actif, tandis que le premier signal de commande SI1 est inactif, la deuxième source de courant I2 conduit, et extrait un courant depuis les bases des premier et deuxième transistors (T1, T2) dont la conduction est ainsi interrompue quasi instantanément. La tension Vref présente aux bornes de l'élément capacitif C1, représentative de la tension Vccd présente à la borne d'entrée au cours de la phase de suivi précédente, est ainsi mémorisée jusqu'à la prochaine phase de suivi.

Les premier et deuxième signaux de commande SI1 et SI2 peuvent être élaborés indépendamment l'un de l'autre à l'extérieur du dispositif de mémorisation (SW1, C1), selon des techniques bien connues de l'homme du métier. Néanmoins, dans l'exemple décrit ici, le dispositif de mémorisation comporte des moyens pour empêcher une conduction simultanée des première et deuxième sources de courant (I1, I2). Ces moyens consistent, dans cet exemple, en un inverseur logique INV, destiné à recevoir en entrée un signal de commande unique Svref, qui correspond ici au deuxième signal de commande SI2, et dont la sortie est destinée à délivrer le premier signal de commande SI1. Les premier et deuxième signaux de commande (SI1, SI2) sont alors en permanence en opposition de phase, et ne peuvent donc être actifs en même temps, ce qui permet d'immuniser l'interrupteur SW1 contre tout court-circuit entre les deux sources de courant (I1, I2). Dans d'autres modes de réalisation, l'inverseur INV pourra être remplacé par des cellules à retard introduisant un déphasage de

180° entre les premier et deuxième signaux de commande (SI1, SI2). Par ailleurs, le dispositif de mémorisation comporte un élément régulateur de tension BF disposé entre la borne de sortie et les bases des premier et deuxième transistors (T1, T2), permettant de limiter l'amplitude des tensions base-émetteur (Vbe1, Vbe2) des premier et deuxième transistors (T1, T2).

L'élément régulateur de tension BF, qui pourra par exemple être de type suiveur, assure que la valeur du potentiel des bases des premier et deuxième transistors (T1, T2) est du même ordre que celle des composantes continues des signaux d'entrée et de sortie (Vccd, Vref). L'amplitude des tensions base-émetteur (Vbe1, Vbe2) des premier et deuxième transistors (T1, T2) restera donc faible, ce qui limite l'usure desdits transistors et contribue à augmenter la durée de vie du dispositif de mémorisation. De plus, cet élément régulateur BF permet d'éviter que de trop fortes tensions base-émetteur (Vbe1, Vbe2) ne déclenchent intempestivement la conduction des premier et deuxième transistors (T1, T2) lorsque la première source de courant I1 n'est pas conductrice.

Enfin, il sera avantageux de pourvoir les premier et deuxième transistors T1 et T2 d'une structure dite à collecteur en anneau. Une telle structure permet d'éviter que d'importantes quantités de charges ne se propagent dans le substrat du circuit intégré sur lequel le dispositif de mémorisation est implanté, lorsque les commutations des transistors sont commandées par de fortes impulsions de courant. De tels phénomènes de propagation provoqueraient la mise en conduction de jonctions parasites existant au sein du circuit intégré, mise en conduction qui risquerait de provoquer la destruction dudit circuit.

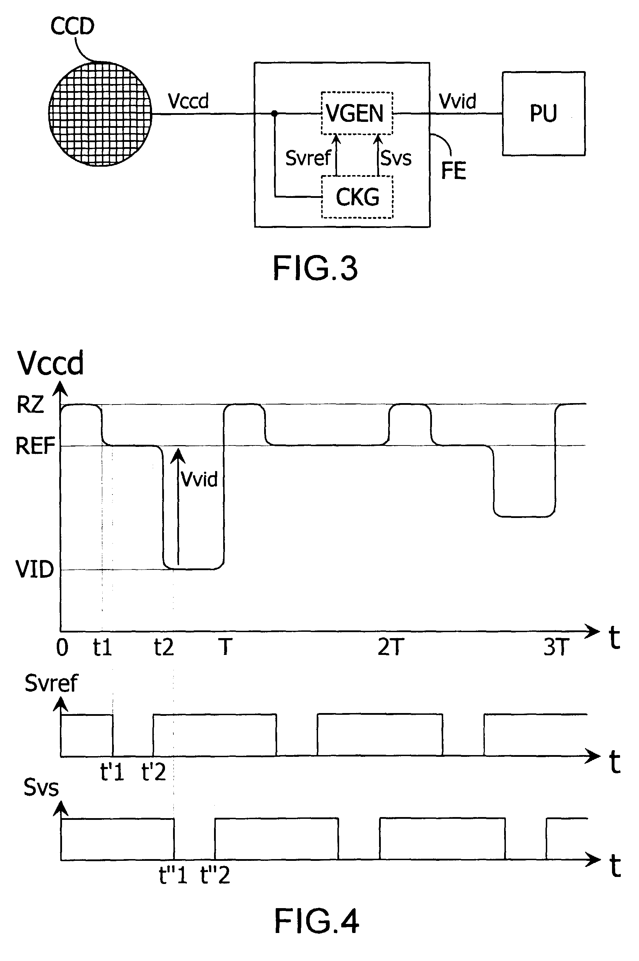

La figure 3 représente très schématiquement une caméra vidéo dans laquelle l'invention est mise en oeuvre. Cette caméra contient:

. un dispositif CCD de détection et de conversion de lumière en un signal électronique pseudo périodique Vccd,

. un étage d'entrée FE destiné à recevoir ledit signal électronique Vccd, et à délivrer un signal vidéo Vvid, et

. une unité de traitement de signal PU destinée à exploiter ledit signal vidéo Vvid, unité qui comportera avantageusement un convertisseur analogique/numérique en vue d'un traitement numérique du signal vidéo Vvid.

Dans cette caméra, l'étage d'entrée FE inclut un dispositif de génération VGEN tel que décrit ci-dessus, destiné à recevoir depuis un générateur d'horloge CKG les signaux de commande (Svref, Svs). Ces signaux sont élaborés sur la base du signal d'entrée Vccd du dispositif de génération VGEN.

La figure 4 représente l'évolution de signaux présents dans une telle caméra, en vue de faciliter la compréhension de l'invention.

Le signal d'entrée Vccd du dispositif de génération VGEN est pseudo périodique de période T. Ce signal Vccd présente successivement, au cours de chaque pseudo période, un niveau dit de remise à zéro RZ, un niveau dit de référence REF et un niveau dit vidéo VID. A l'instant 0, et d'une manière générale, au début d'une pseudo période du signal Vccd, celui-ci prend le niveau de remise à zéro RZ. Cet événement est détecté par le générateur d'horloge CKG, qui déclenche des temporisations. Le signal Vccd reste au niveau de remise à zéro RZ pendant un intervalle prédéterminé [0;t1], et les signaux de commande Svref et Svs sont actifs, ce qui signifie que les premier et deuxième dispositifs de mémorisation contenus dans le dispositif de génération VGEN sont en phase de maintien. Le signal vidéo Vvid délivré par le dispositif de génération VGEN est donc celui de la pseudo période précédente. A l'instant t1, le signal Vccd prend le niveau de référence REF. A un instant t'1. prédéterminé, suivant de peu l'instant t1, une première temporisation arrive à son terme et le signal de commande Svref devient inactif. Le premier dispositif de mémorisation entre alors en phase de suivi, le deuxième dispositif de mémorisation étant alors toujours dans la phase de maintien. A un instant t'2 prédéterminé, précédant de peu un instant t2 où le signal Vccd prend le niveau vidéo VID, une deuxième temporisation arrive à son terme et le signal de commande Svref redevient inactif, et le premier dispositif de mémorisation entre à nouveau en phase de maintien, son signal de sortie représentant alors le nouveau niveau de référence REF. A un instant t''1 prédéterminé, suivant de peu l'instant t2, une troisième temporisation arrive à son terme et le signal de commande Svs devient inactif. Le deuxième dispositif de mémorisation entre alors en phase de suivi, le deuxième dispositif de mémorisation restant dans la phase de maintien. A un instant t''2 prédéterminé, précédant de peu l'instant T où le signal N/ccd entre dans la pseudo période suivante et reprend le niveau de remise à zéro RZ, une quatrième temporisation arrive à son terme et le signal de commande Svs redevient inactif, et le deuxième dispositif de mémorisation entre à nouveau en phase de maintien, son signal de sortie représentant alors le nouveau niveau vidéo VID. Le soustracteur SUB, dont on aura avantageusement prévu l'inhibition pendant l'intervalle [t'1;t''2] délivre alors un nouveau signal vidéo Vvid représentatif de la différence entre les niveaux de référence et vidéo REF et VID pendant la période [0;T].

**Revendications**

1. Dispositif de mémorisation muni de bornes d'entrée et de sortie respectivement destinées à recevoir et à délivrer des signaux d'entrée et de sortie, dispositif incluant un élément capacitif, dont une borne forme la borne de sortie du dispositif et est reliée à la borne d'entrée via un interrupteur, dispositif caractérisé en ce que l'interrupteur comprend un premier et un deuxième transistor bipolaire, dont les trajets de courant principaux sont disposés tête-bêche entre les bornes d'entrée et de sortie, l'interrupteur étant en outre muni de moyens de contrôle pour alternativement extraire ou injecter du courant dans les bases des premier et deuxième transistors.

2. Dispositif de mémorisation selon la revendication 1, caractérisé en ce que les moyens de contrôle incluent une première et une deuxième source de courant contrôlable, respectivement disposées entre les bases des premier et deuxième transistors et des première et deuxième bornes d'alimentation, les bases des premier et deuxième transistors étant court-circuitées.

3. Dispositif de mémorisation selon la revendication 2, caractérisé en ce qu'il comporte des moyens pour empêcher une conduction simultanée des première et deuxième sources de courant.

4. Dispositif de mémorisation selon la revendication 2, caractérisé en ce qu'il comporte un élément régulateur de tension disposé entre la borne de sortie et les bases des premier et deuxième transistors, permettant de limiter l'amplitude des tensions base-émetteur des premier et deuxième transistors.

5. Dispositif de mémorisation selon la revendication 1, caractérisé en ce que les premier et deuxième transistors sont de type NPN avec collecteur en anneau.

6. Dispositif de génération d'un signal vidéo, muni d'une entrée destinée à recevoir un signai d'entrée pseudo périodique présentant successivement, au cours de chaque pseudo période, un niveau dit de référence et un niveau dit vidéo, et d'une sortie destinée à délivrer un signal de sortie représentatif d'une différence entre lesdits niveaux, dispositif comportant:

.  un premier et un deuxième dispositif de mémorisation, respectivement destinés à mémoriser les niveaux de référence et vidéo à chaque pseudo période, et

.  un soustracteur destiné à opérer une différence entre lesdits niveaux,
   dispositif caractérisé en ce que les premier et deuxième dispositifs de mémorisation sont conformes à la revendication 1

7.  Dispositif d'acquisition d'images, contenant:

.  un dispositif de détection et de conversion de lumière en un signal électronique pseudo périodique,

.  un étage d'entrée destiné à recevoir ledit signal électronique, et à délivrer un signal vidéo, et

.  une unité de traitement de signal destinée à exploiter ledit signal vidéo,
   dispositif d'acquisition caractérisé en ce que l'étage d'entrée inclut un dispositif de génération conforme à la revendication 6.

**FIG.1**

**FIG.2**

FIG.3

FIG.4

**Office européen des brevets**

## RAPPORT DE RECHERCHE EUROPEENNE

Numéro de la demande

EP 00 20 1676

### DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.7) |
|---|---|---|---|
| D,Y | US 4 987 321 A (TOOHEY WILLIAM J) 22 janvier 1991 (1991-01-22) * colonne 2, ligne 53 - colonne 3, ligne 17; figure 1 * --- | 1-3,6,7 | G11C27/02 H03K17/66 |
| Y | US 5 027 003 A (HAIGHT MICHAEL H ET AL) 25 juin 1991 (1991-06-25) * colonne 5, ligne 20 - ligne 49; figure 3 * * colonne 9, ligne 36 - ligne 41 * --- | 1-3,6,7 | |
| A | US 5 832 305 A (BRIGGS BARRY D ET AL) 3 novembre 1998 (1998-11-03) * colonne 2, ligne 36 - colonne 3, ligne 31; figure 2 * --- | 1-7 | |
| A | FR 2 078 415 A (SIEMENS AG) 5 novembre 1971 (1971-11-05) * le document en entier * ----- | 1-7 | |

| DOMAINES TECHNIQUES RECHERCHES (Int.Cl.7) |
|---|
| G11C H03K |

Le présent rapport a été établi pour toutes les revendications

| Lieu de la recherche | Date d'achèvement de la recherche | Examinateur |
|---|---|---|
| LA HAYE | 31 juillet 2000 | Beasley-Suffolk, D |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P04C02)

## ANNEXE AU RAPPORT DE RECHERCHE EUROPEENNE
## RELATIF A LA DEMANDE DE BREVET EUROPEEN NO.

EP 00 20 1676

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

31-07-2000

| Document brevet cité au rapport de recherche | | Date de publication | Membre(s) de la famille de brevet(s) | | Date de publication |
|---|---|---|---|---|---|
| US 4987321 | A | 22-01-1991 | AUCUN | | |
| US 5027003 | A | 25-06-1991 | AUCUN | | |
| US 5832305 | A | 03-11-1998 | AUCUN | | |
| FR 2078415 | A | 05-11-1971 | DE | 2006166 A | 19-08-1971 |
| | | | GB | 1319167 A | 06-06-1973 |
| | | | NL | 7101371 A | 13-08-1971 |

EPO FORM P0460

Pour tout renseignement concernant cette annexe : voir Journal Officiel de l'Office européen des brevets, No.12/82